# EUROPEAN PATENT APPLICATION

(11) **EP 4 768 924 A1**
(43) Date of publication of application: **01.07.2026**
(21) Application number: 25226182.1
(22) Date of filing: 22.12.2025
(51) Int. Cl.: G01R 15/18, G01R 15/20

(54) **CURRENT MEASUREMENT DEVICE AND CURRENT MEASUREMENT METHOD**

(30) Priority: 25.12.2024 JP 2024228364
(71) Applicant: Yokogawa Electric Corporation, Musashino-shi, Tokyo 180-8750 (JP)
(72) Inventor: TERAO, Minako, 180-8750 Musashino-shi, Tokyo (JP); SAKAMAKI, Yasuo, 180-8750 Musashino-shi, Tokyo (JP); TAKENAKA, Kazuma, 180-8750 Musashino-shi, Tokyo (JP); NOGUCHI, Naoki, 180-8750 Musashino-shi, Tokyo (JP)
(74) Representative: Winter, Brandl - Partnerschaft mbB

(57) **Abstract**

A current measurement device (1) includes a magnetic shield (13) having a notch portion (20) for taking a magnetic field generated by a current flowing through a conductor (MC) to be measured into an internal space; a sensor (14) that is disposed in the internal space of the magnetic shield and outputs a voltage corresponding to a magnetic field at a position where the sensor (14) is disposed; and a circuit unit (12) that detects the current flowing through the conductor (MC) to be measured based on the voltage output from the sensor (14), and the magnetic shield (13) includes a first correction unit (A) that corrects the magnetic field measured by the sensor (14) to reduce influence of magnetic flux density saturation of the magnetic shield, and/or magnetic shield (13) or the circuit unit (12) includes a second correction unit (B) that corrects the voltage output from the sensor to reduce the influence of the magnetic flux density saturation of the magnetic shield (13).

## Description

### BACKGROUND OF THE INVENTION

### 1. Field of the Invention

The present disclosure relates to a current measurement device and a current measurement method.

### 2. Description of the Related Art

There are current measurement devices that measure a magnetic field generated from a current flowing through a conductor to be measured and measure the current flowing through the conductor to be measured from the measured magnetic field.

Such current measurement devices include a current measurement device in which a sensor head has a substantially U-shaped magnetic shield, a conductor to be measured is installed in a notch portion of the magnetic shield, and a magnetic sensor is provided in an internal space of the magnetic shield.

In such a current measurement device, the magnetic sensor measures a magnetic field generated by a current flowing through the conductor to be measured, and measures the current flowing through the conductor to be measured based on the measured magnetic field.
Patent document 1: Japanese Laid-open Patent Publication No. 2022-29714
Patent document 2: Japanese Laid-open Patent Publication No. 2019-184355
Patent document 3: Japanese Laid-open Patent Publication No. 2016-125907
Patent document 4: Japanese Laid-open Patent Publication No. 2013-200301

### SUMMARY OF THE INVENTION

However, in a current measurement device of Japanese Unexamined Patent Application Publication No. 2022-29714, a magnetic sensor is accommodated in an internal space of a hollow magnetic shield having a notch portion, and therefore when a large current flows through a conductor to be measured, a magnetic flux density sensed by the magnetic sensor is not proportional to the current due to saturation of the magnetic flux density of the magnetic shield. This may disturb a measured value and may make it impossible to accurately measure the current flowing through the conductor to be measured.

The present disclosure has been made in view of the above circumstances, and provides a current measurement device that reduces influence of magnetic flux density saturation of a magnetic shield and accurately measures a current flowing through a conductor to be measured.

According to an aspect of an embodiment, a current measurement device includes a magnetic shield having a notch portion for taking a magnetic field generated by a current flowing through a conductor to be measured into an internal space, a sensor that is disposed in the internal space of the magnetic shield and outputs a voltage corresponding to a magnetic field at a position where the sensor is disposed, and a circuit unit configured to detect the current flowing through the conductor to be measured based on the voltage output from the sensor, wherein the magnetic shield includes a first correction unit configured to correct the magnetic field measured by the sensor to reduce influence of magnetic flux density saturation of the magnetic shield, and/or the magnetic shield or the circuit unit configured to include a second correction unit configured to correct the voltage output from the sensor to reduce the influence of the magnetic flux density saturation of the magnetic shield.

The current measurement device of the embodiment can reduce influence of magnetic saturation of a magnetic shield and accurately measure a current flowing through a conductor to be measured due to reduced hysteresis and improvement of linearity.

### BRIEF DESCRIPTION OF THE DRAWINGS

FIG. 1 is a diagram for describing an outline of a current measurement device according to an embodiment;
FIG. 2 is a diagram illustrating an appearance of a current measurement device according to a first embodiment;
FIG. 3 is a diagram for describing a cross section of a sensor head of the current measurement device according to the first embodiment when viewed in a front-rear direction orthogonal to an extending direction of a conductor to be measured and a perpendicular direction;
FIG. 4 is a diagram illustrating a magnetic shield in the current measurement device according to the first embodiment;
FIG. 5 is a diagram illustrating the magnetic shield according to a first modification in the current measurement device according to the first embodiment;
FIG. 6 is a diagram illustrating a short-circuit winding wound around the magnetic shield according to a second modification in the current measurement device according to the first embodiment;
FIG. 7 is a diagram illustrating magnetic flux densities before and after correction using the short-circuit winding of the current measurement device according to the first embodiment;
FIG. 8 is a diagram for describing an outline of a current measurement device according to a second embodiment;
FIG. 9 is a diagram illustrating a relationship between a voltage detected by a magnetic sensor and a current flowing through a conductor to be measured;
FIG. 10 is a diagram illustrating an example of a pass characteristic of a correction circuit;
FIG. 11 is a diagram illustrating a curve indicating a voltage that is a measurement value before correction and a curve indicating a voltage that is a measurement value after correction in the current measurement device according to the second embodiment;
FIG. 12 is a diagram illustrating a circuit configuration of a circuit unit of a current measurement device according to a third embodiment;
FIG. 13 is a flowchart for describing operation of the current measurement device according to the third embodiment;
FIG. 14 is a diagram illustrating a configuration of a current measurement device according to a fourth embodiment;
FIG. 15 is a diagram illustrating a magnetic shield according to a first modification in the current measurement device according to the fourth embodiment;
FIG. 16 is a diagram for describing a magnetic shield of a current measurement device according to a fifth embodiment;
FIG. 17 is a diagram illustrating a difference between a cross-sectional area of a lower portion of the magnetic shield and cross-sectional areas of a right side portion, a left side portion, and an upper portion in the current measurement device according to the fifth embodiment;
FIG. 18 is a diagram for describing a first modification of the magnetic shield in the current measurement device according to the fifth embodiment;
FIG. 19 is a block diagram illustrating a configuration of a main part of a current measurement device according to a sixth embodiment; and
FIG. 20 is a cross-sectional view of a magnetic shield of a sensor head included in a current measurement device according to a seventh embodiment.

### DETAILED DESCRIPTION OF THE PREFERRED EMBODIMENTS

Hereinafter, preferred embodiments of the present disclosure will be described in detail with reference to the accompanying drawings. In the present specification and the drawings, constituent elements having substantially identical functional configurations are given identical reference signs, and repeated description thereof is omitted.

### <1. Outline of embodiments>

### <1.1. Coreless current sensor>

In the technical field of vehicles, conventionally, a magnetic sensor is provided for a bus bar and a magnetic shield is provided around the magnetic sensor to measure a current flowing through the bus bar.

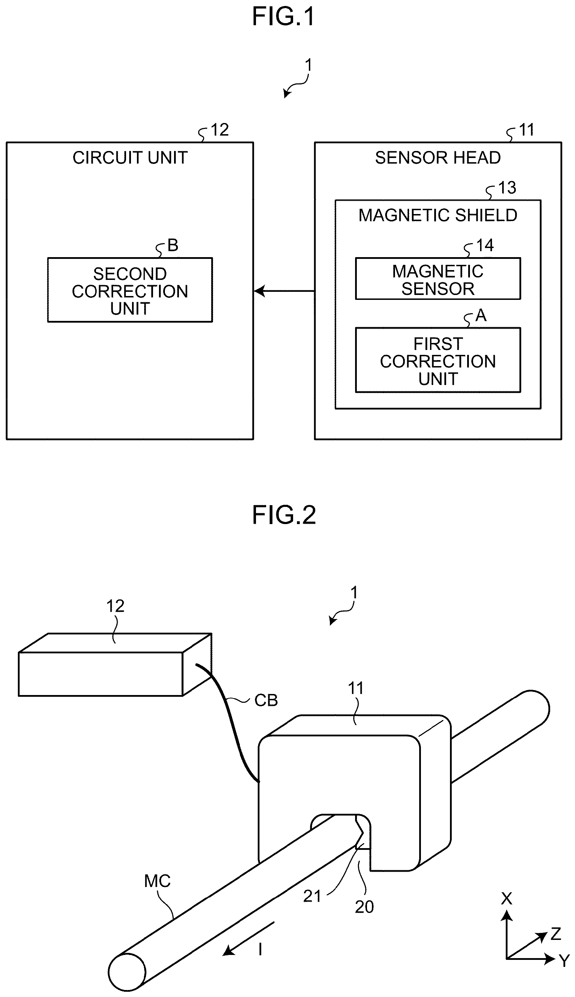

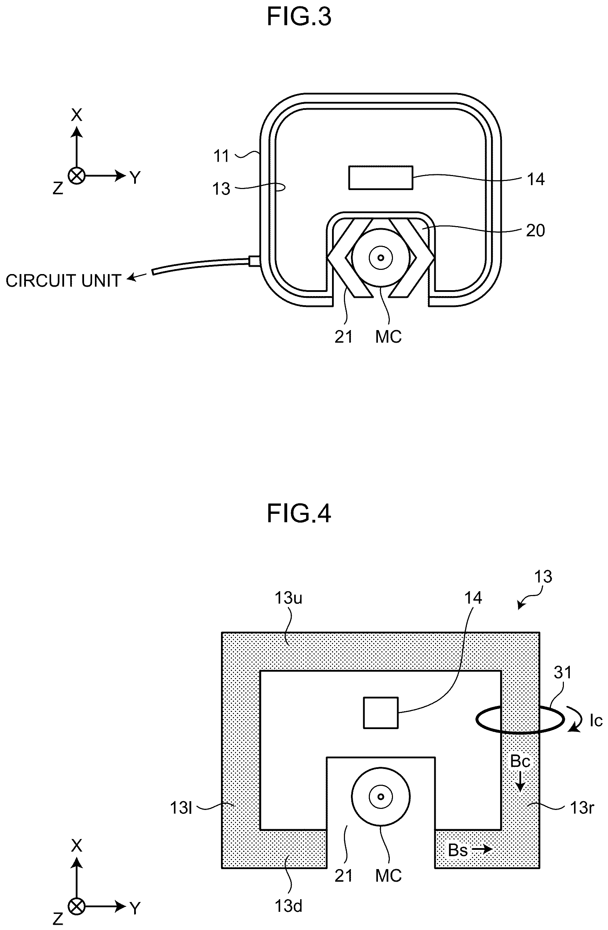

For example, Japanese Unexamined Patent Application Publication No. 2019-184355 discloses a current measurement device including a magnetic detection element that detects a magnetic field generated from a current path, a shield plate disposed around the magnetic detection element, and the like (Abstract, FIGS. 2 and 3, etc. of Japanese Unexamined Patent Application Publication No. 2019-184355). As a magnetic sensor of a coreless magnetic detection element, a Hall element, a magnetic field resistance element, and a Hall IC are exemplified (paragraph 0031 of Japanese Unexamined Patent Application Publication No. 2019-184355).

In addition, Japanese Unexamined Patent Application Publication No. 2016-125907 discloses a current sensor including a bus bar, a magnetoelectric conversion element, a magnetic shield plate, and the like (Abstract, FIGS. 1 and 3, etc. of Japanese Unexamined Patent Application Publication No. 2016-125907).

It is assumed that the current measurement devices disclosed in Japanese Unexamined Patent Application Publication No. 2019-184355 and Japanese Unexamined Patent Application Publication No. 2016-125907 continue to be used while being attached to a bus bar of a vehicle. For example, Japanese Unexamined Patent Application Publication No. 2019-184355 describes an electric vehicle equipped with a coreless current measurement device at the beginning of the embodiment (Paragraph 0014, FIG. 1, etc. of Japanese Unexamined Patent Application Publication No. 2019-184355). Japanese Unexamined Patent Application Publication No. 2016-125907 describes that a current sensor is provided in an internal space of an inverter mounted on an electric vehicle at the beginning of the embodiment (Paragraph 0012, FIG. 1, etc. of Japanese Unexamined Patent Application Publication No. 2016-125907). Further, claim 1 of Japanese Unexamined Patent Application Publication No. 2016-125907 specifies a configuration including a bus bar as a current sensor.

The current measurement device of the present embodiment is a current sensor attachable to and detachable from a current cable including a bus bar and the like, and examples of such a current sensor include that disclosed in Japanese Unexamined Patent Application Publication No. 2022-29714 and that disclosed in Japanese Unexamined Patent Application Publication No. 2013-200301.

Japanese Unexamined Patent Application Publication No. 2022-29714 and Japanese Unexamined Patent Application Publication No. 2013-200301 disclose a configuration of a current measurement device in which an electric wire is passed through a notch portion of a magnetic shield and a magnetic sensor is disposed inside the magnetic shield (FIG. 3 of Japanese Unexamined Patent Application Publication No. 2022-29714, Abstract of Japanese Unexamined Patent Application Publication No. 2013-200301, etc.). However, the current measurement devices disclosed in Japanese Unexamined Patent Application Publication No. 2022-29714 and Japanese Unexamined Patent Application Publication No. 2013-200301 do not disclose reducing influence of magnetic flux density saturation of a magnetic shield and accurately measuring a current flowing through a conductor to be measured.

### <1.2. Description of outline of embodiments>

Next, an outline of a current measurement device of the present embodiment will be described. The current measurement device of the present embodiment reduces influence of magnetic flux density saturation of a magnetic shield, and obtains an accurate current measurement value due to reduced hysteresis and improved linearity.

FIG. 1 is a diagram for describing an outline of a current measurement device 1 according to the embodiment. As illustrated in FIG. 1, the current measurement device 1 includes a sensor head 11 and a circuit unit 12. Note that the sensor head 11 and the circuit unit 12 do not need to be separated, and may be integrated.

The sensor head 11 includes a magnetic shield 13. The magnetic shield 13 includes a magnetic sensor 14 and a first correction unit A. The magnetic sensor 14 is provided in an internal space of the magnetic shield 13, and outputs a voltage corresponding to a direct-current magnetic field and a low-frequency alternating-current magnetic field generated by a current flowing through a conductor to be measured. Note that the magnetic sensor 14 may output a current instead of a voltage. It is assumed that the current flowing through the conductor to be measured is an alternating current, unless otherwise specified.

The first correction unit A corrects a magnetic field measured by the magnetic sensor 14 to reduce influence of magnetic flux density saturation of the magnetic shield 13. Specifically, the first correction unit A may perform correction for reducing influence of the magnetic flux density saturation of the magnetic shield 13 by generating, in a wall of the magnetic shield 13, a magnetic field in a direction opposite to a direction of the magnetic field generated by the current flowing through the conductor to be measured. The first correction unit A is provided in a case where correction is performed on the magnetic shield 13 side, and need not be provided in a case where correction is not performed on the magnetic shield 13 side.

In a case where the first correction unit A is provided in the magnetic shield 13, the first correction unit A corrects a voltage corresponding to the magnetic field detected by the magnetic sensor 14 and outputs the corrected voltage to the circuit unit 12.

The circuit unit 12 measures the current flowing through the conductor to be measured based on the voltage corresponding to the magnetic field output from the magnetic sensor 14, and outputs or displays a measurement result to an outside.

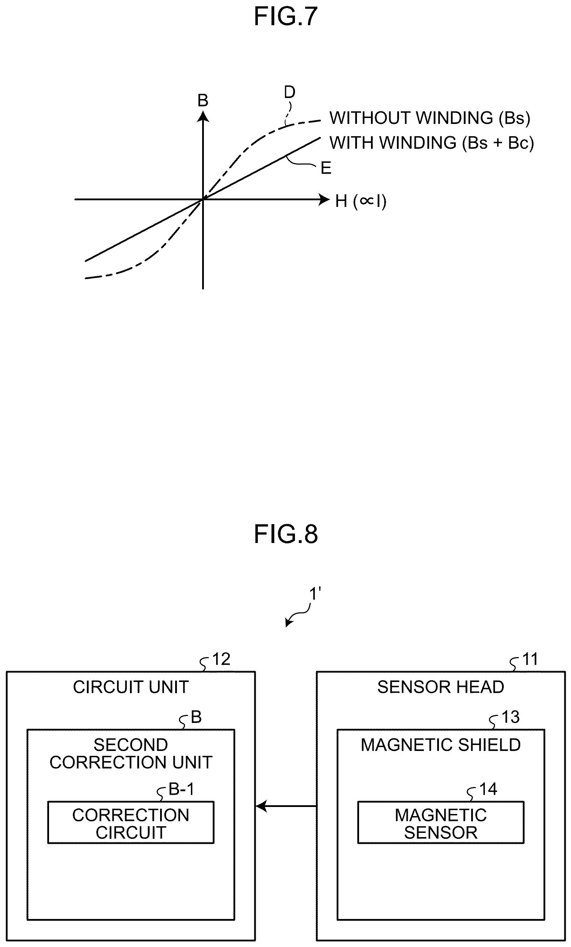

On the other hand, as illustrated in FIG. 8, in the embodiment, the correction of the voltage of the magnetic field detected by the magnetic sensor 14 may be performed in the circuit unit 12. The circuit unit 12 includes a second correction unit B that performs calculation on a voltage corresponding to a magnetic field in the wall of the magnetic shield 13 detected by the magnetic sensor 14. The second correction unit B corrects the voltage corresponding to the magnetic field detected by the magnetic sensor 14 to reduce influence of the magnetic flux density saturation of the magnetic shield 13. A correction method on the circuit unit 12 side will be described in an embodiment described later.

Note that in the following first to seventh embodiments, either the correction performed by the first correction unit A on the magnetic shield 13 side or the correction performed by the second correction unit B on the circuit unit 12 side is performed, but the correction may be performed on both the magnetic shield 13 side and the circuit unit 12 side. The second correction unit B may be provided on the magnetic shield 13 side and integrated with the first correction unit A. In this case, the second correction unit B may further correct the voltage corrected by the first correction unit A to reduce the influence of the magnetic flux density saturation of the magnetic shield 13 by the second correction unit B.

In this way, the current measurement device 1 of the embodiment can detect an accurate value of the current flowing through the conductor to be measured in consideration of the influence of the magnetic flux density saturation of the magnetic shield 13.

Next, current measurement devices 1 of the first to seventh embodiments will be described.

### <2. First embodiment>

A current measurement device 1 according to the first embodiment will be described. The current measurement device 1 of the first embodiment suppresses magnetic flux density saturation on the magnetic shield 13 side and accurately detects a current flowing through a conductor to be measured.

### <2.1. Configuration>

FIG. 2 is a diagram illustrating an appearance of the current measurement device 1 according to the first embodiment. As illustrated in FIG. 2, the current measurement device 1 includes a sensor head 11 and a circuit unit 12 connected to the sensor head 11 by a cable CB.

The sensor head 11 is a member for electrically detecting a current I flowing through a conductor MC to be measured in a non-contact manner. The sensor head 11 is used as a probe for electrically detecting the current I flowing through the conductor MC to be measured in a non-contact manner. Note that the sensor head 11 is desirably as small as possible in order to enable detection of the current I even in a situation where a space around the conductor MC to be measured is limited.

As illustrated in FIG. 2, the sensor head 11 is disposed fixedly relative to the conductor MC to be measured in a case where the current I flowing through the conductor MC to be measured is detected. The sensor head 11 has a substantially U-shape having a notch portion 20 in a lower portion of a rectangular shape. In the notch portion 20, the conductor MC to be measured is inserted, and a fixing mechanism 21 for fixing the conductor MC to be measured is provided. The fixing mechanism 21 has a structure that uniquely determines a positional relationship between a center of the conductor MC to be measured and the magnetic sensor 14 regardless of the diameter of the conductor MC to be measured. That is, the sensor head 11 is brought into a state of being physically in contact with the conductor MC to be measured by the fixing mechanism 21. However, the sensor head 11 is electrically insulated from the conductor MC to be measured, and can measure the current I flowing through the conductor MC to be measured in a non-contact manner. The cable CB connected to the circuit unit 12 is connected to the sensor head 11.

The circuit unit 12 measures the current I flowing through the conductor MC to be measured based on the voltage output from the sensor head 11, and displays a measurement result. The circuit unit 12 outputs or displays the measurement result of the current I to the outside. The detection result may be a voltage signal, and the voltage signal may be the voltage itself from the sensor head 11 or may be a voltage that has been processed (for example, amplified) by a circuit. Any cable can be used as the cable CB connecting the sensor head 11 and the circuit unit 12. The cable CB is desirably flexible, is desirably easy to handle, and is desirably less likely to be disconnected.

FIG. 3 is a diagram for describing a cross section of the sensor head 11 of the current measurement device 1 according to the first embodiment when viewed in a front-rear direction orthogonal to an extending direction of the conductor MC to be measured and a perpendicular direction. In FIG. 3, the X-axis direction is the up-down direction of the sensor head 11, the Y-axis direction is the left-right direction of the sensor head 11, and the Z-direction is the front-rear direction of the sensor head 11.

As illustrated in FIG. 3, the sensor head 11 has a substantially quadrangular cross section in the XY direction, and has the notch portion 20 provided at a lower portion in the X-axis direction so that a part of the conductor MC to be measured is disposed in an internal space of the magnetic shield 13.

The notch portion 20 of the sensor head 11 is provided with the fixing mechanism 21 that is provided below the magnetic shield 13 in the X-axis direction and fixes a part of the conductor MC to be measured extending in the Z-axis direction. The fixing mechanism 21 fixes the sensor head 11 to the conductor MC to be measured such that a distance between the center of the conductor MC to be measured inserted through the notch portion of the magnetic shield 13 and the magnetic sensor 14 becomes a predetermined reference distance (r).

The magnetic shield 13 is provided on the sensor head 11 so as to cover the fixing mechanism 21 and a part of the conductor MC to be measured. The magnetic sensor 14 is provided in the internal space of the magnetic shield 13 and is located in proximity to the conductor MC to be measured.

The magnetic shield 13 has a notch portion 20 similarly to the sensor head 11. The conductor MC to be measured is inserted into the notch portion 20. The conductor MC to be measured is fixed to the magnetic shield 13 by the fixing mechanism 21.

The magnetic sensor 14 can be used with the highest sensitivity when a center of a magnetic sensing surface of the magnetic sensor 14 is placed on the X-axis passing the center of the conductor MC to be measured on an XY plane including a thickness center position of the magnetic shield 13 in the z-axis direction, and the direction of the magnetic sensing surface of the magnetic sensor 14 coincides with a tangential direction of the conductor MC to be measured, that is, the Y-axis direction. In particular, as the magnetic sensor 14 is disposed closer to the notch portion 20, a magnetic field generated by a current to be measured becomes stronger, which is advantageous for measurement. In other words, the magnetic shield 13 has a substantially U-shaped cross section on the XY plane, and the conductor MC to be measured is fixed at a center of a lower portion of the magnetic shield 13 (at a tip portion of the substantially U-shape) by the fixing mechanism 21. The magnetic sensor 14 detects a direct-current magnetic field and a low-frequency alternating-current magnetic field at the position in the internal space of the magnetic shield 13.

The magnetic sensor 14 is disposed in proximity to the conductor MC to be measured so as to be able to detect the magnetic field generated by the current flowing through the conductor MC to be measured. The magnetic sensor 14 includes, for example, a coil for high frequency detection and a Hall element for low frequency detection, but may be a sensor having another configuration. A voltage corresponding to the magnetic field measured by the magnetic sensor 14 is output to the circuit unit 12 through the cable CB.

FIG. 4 is a diagram illustrating the magnetic shield 13 in the current measurement device 1 according to the first embodiment. The magnetic shield 13 takes a part of the magnetic field generated by the current flowing through the conductor MC to be measured into the wall. The magnetic shield 13 has a box shape and has a substantially U-shaped cross section in the XY direction, and includes a right side portion 13r, a left side portion 131, an upper portion 13u, and a lower portion 13d. In other words, the magnetic shield 13 has a wall that defines an internal space. The wall of the magnetic shield 13 includes a side wall extending along the extending direction of the conductor MC to be measured. In other words, the magnetic shield 13 has a hollow box shape having an internal space. The wall extends so as to have a substantially U-shape when the magnetic shield 13 is viewed from the front.

As illustrated in FIG. 4, a short-circuit winding 31 wound once is wound around a part of the magnetic shield 13. Specifically, as illustrated in FIG. 4, the short-circuit winding 31 is wound around the magnetic shield 13. Note that the short-circuit winding 31 may be wound around any part of the magnetic shield 13. Specifically, the short-circuit winding 31 is wound once around the wall of the right side portion 13r of the magnetic shield 13 so as to pass through the internal space. The short-circuit winding 31 is wound around a part of the wall so as to extend in a direction intersecting the extending direction of the wall of the magnetic shield 13. The short-circuit winding 31 is wound in a continuous ring shape around the wall of the magnetic shield 13 so as to pass through the internal space, and is electrically short-circuited.

In a case where the magnetic field generated by the current flowing through the conductor MC to be measured causes the magnetic shield 13 wall to reach magnetic flux density saturation, no more magnetic flux is input into the magnetic shield 13 wall. Therefore, the magnetic field input to the magnetic sensor 14 increases and affects a current measurement value.

On the other hand, in the current measurement device 1 according to the first embodiment, the magnetic flux generated in the wall of the magnetic shield 13 is electromagnetically coupled to the short-circuit winding 31, as illustrated in FIG. 4. Since the short-circuit winding 31 is short-circuited, a short-circuit current Ic flows so as to cancel out the magnetic flux generated in the magnetic shield 13 according to the Lenz's law.

Therefore, according to the current measurement device 1 according to the first embodiment, the magnetic field generated in the magnetic shield 13 is canceled out by the short-circuit winding 31. This produces an effect of making magnetic saturation less likely to occur, thereby allowing the magnetic sensor 14 to perform measurement while improving the influence of the magnetic flux density saturation of the magnetic shield 13.

### <First modification>

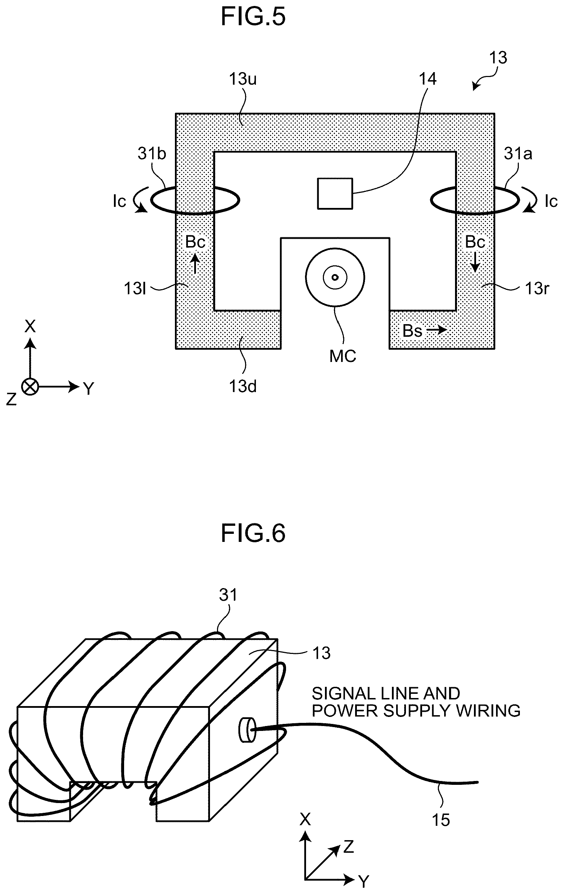

Next, a first modification of the current measurement device 1 according to the first embodiment will be described. The short-circuit winding 31 may be a plurality of short-circuit windings. FIG. 5 is a diagram illustrating the magnetic shield 13 according to the first modification in the current measurement device 1 according to the first embodiment. As illustrated in FIG. 5, a short-circuit winding 31a is wound once around the right side portion 13r of the magnetic shield 13 and a short-circuit winding 31b is wound once around the left side portion 131 of the magnetic shield 13 according to the first modification in the current measurement device 1 according to the first embodiment. The short-circuit windings 31a and 31b are each wound in a continuous ring shape around the wall of the magnetic shield 13 so as to pass through the internal space, and are electrically short-circuited.

By thus winding the short-circuit winding 31a and the short-circuit winding 31b around the magnetic shield 13, a short-circuit current similarly flows through each short-circuit winding so as to cancel out a magnetic flux according to the Lenz's law. Since the short-circuit current is distributed to the short-circuit winding 31a and the short-circuit winding 31b, the short-circuit current is halved in this case.

Therefore, by using the plurality of short-circuit windings 31a and 31b, the short-circuit current is halved as compared with the case where one short-circuit winding is used, and therefore a thin short-circuit winding can be used. Furthermore, since the plurality of short-circuit windings 31a and 31b can be arranged at different positions (for example, the upper portion 13u and the lower portion 13d), the magnetic field generated in the magnetic shield 13 can be finely controlled.

### <Second modification>

Next, a second modification of the current measurement device 1 according to the first embodiment will be described. The short-circuit winding 31 may be a short-circuit winding wound a plurality of times around the magnetic shield 13. FIG. 6 is a diagram illustrating a state of the short-circuit winding 31 wound a plurality of times around the magnetic shield 13 according to the second modification in the current measurement device 1 according to the first embodiment. As illustrated in FIG. 6, in the magnetic shield 13 according to the second modification in the current measurement device 1 according to the first embodiment, the short-circuit winding 31 is wound in a plurality of turns around the outside of the magnetic shield 13, and winding start and end are electrically short-circuited. By thus using the short-circuit winding 31 wound around the magnetic shield 13 a plurality of times, the short-circuit current is reduced as compared with the case where the short-circuit winding 31 is wound around the magnetic shield 13 once, and therefore a thin short-circuit winding can be used as the short-circuit winding 31.

FIG. 6 illustrates a state in which a signal line and power supply wiring 15 is inserted into a right side portion of the magnetic shield 13. The signal line and power supply wiring 15 includes a signal line for the voltage measured by the magnetic sensor 14 of the sensor head 11 and a power supply line for power supplied to the sensor head.

### <2.2. Operation>

Next, operation of the current measurement device 1 according to the first embodiment will be described. When a current flows through the conductor MC to be measured and a magnetic field is generated in the magnetic shield 13, a part of the magnetic field having a magnetic flux density Bs is generated in the wall of the magnetic shield 13. Since the short-circuit winding 31 (or the short-circuit winding 31a and the short-circuit winding 31b) is short-circuited, the current Ic flows in a direction that hinders generation of the magnetic field according to the Lenz's law. As a result, the magnetic flux decreases, and an effect of reducing the magnetic flux density saturation in the wall of the magnetic shield 13 is produced.

FIG. 7 is a diagram illustrating magnetic flux densities before and after correction using the short-circuit winding 31 of the current measurement device 1 according to the first embodiment. In FIG. 7, the dotted line D indicates the magnetic flux density Bs that is not corrected by the short-circuit winding 31 of the magnetic shield 13. The solid line E indicates the magnetic flux density (Bs + Bc) corrected by the short-circuit winding 31 of the magnetic shield 13. The horizontal axis H is a magnetic field corresponding to the current flowing through the conductor MC to be measured.

As illustrated in FIG. 7, the solid line E indicating the magnetic flux density (Bs + Bc) corrected by the winding 31 of the magnetic shield 13 is more linear than the dotted line D indicating the magnetic flux density Bs that is not corrected by the winding 31 of the magnetic shield 13. Therefore, by performing correction in the wall of the magnetic shield 13, the magnetic flux density in the wall of the magnetic shield 13 can be suppressed to less than the magnetic flux saturation density, and a magnetic material can be used in the linear region of the B-H curve.

The voltage of the magnetic field of the current I flowing through the conductor MC to be measured is detected by the magnetic sensor 14. However, when the magnetic flux in the magnetic shield 13 reaches magnetic flux density saturation, the magnetic flux in the magnetic sensor region starts to increase, and the relationship between the voltage (magnetic field) detected by the magnetic shield magnetic sensor 14 and the current I becomes nonlinear. As a result, the current I cannot be accurately measured by the magnetic sensor 14.

On the other hand, in a case where the short-circuit winding 31 is provided around the magnetic shield 13 as in the current measurement device 1 of the first embodiment, magnetic saturation in the magnetic shield 13 is suppressed by the short-circuit winding 31. Therefore, the current measurement device 1 of the first embodiment can make the relationship between the voltage (magnetic field) detected by the magnetic sensor 14 and the current I linear. As a result, the current I can be accurately measured by the magnetic sensor 14.

### <2.3. Effects>

Therefore, according to the current measurement device 1 of the first embodiment, the short-circuit winding 31 (or the short-circuit winding 31a and the short-circuit winding 31b) generates a magnetic field in a direction of reducing the magnetic flux density saturation of the magnetic shield 13, and therefore the current measurement device 1 is less affected by the magnetic flux density saturation of the magnetic shield 13. As a result, the current measurement device 1 of the first embodiment can accurately measure the current flowing through the conductor MC to be measured.

Basically, a magnetic material is less likely to reach magnetic saturation as the volume increases. Therefore, as the thickness of the wall of the magnetic shield 13 increases, the magnetic flux saturation density increases, and the magnetic shield 13 is less likely to reach magnetic saturation. According to the current measurement device 1 of the first embodiment, the influence of magnetic saturation can be reduced, and the wall thickness of the magnetic shield 13 can be reduced accordingly. As a result, the magnetic shield 13 can be reduced in size and weight.

In addition, according to the current measurement device 1 of the first embodiment, in a case where the plurality of short-circuit windings 31a and 31b are used or the short-circuit winding 31 wound in a plurality of turns is used, the magnitude of the current flowing through the short-circuit windings to generate a magnetic field of the same magnitude is reduced, and a thin short-circuit winding (a short-circuit winding having a small current capacity) can be used accordingly.

### <3. Second Embodiment>

Next, a current measurement device according to the second embodiment will be described. The current measurement device according to the second embodiment corrects a voltage corresponding to a magnetic field measured by a magnetic sensor 14 in a circuit unit 12.

### <3.1. Configuration>

FIG. 8 is a diagram for describing an outline of the current measurement device 1' according to the second embodiment. As illustrated in FIG. 8, unlike the current measurement device 1 of the first embodiment, the current measurement device 1' according to the second embodiment corrects an analog voltage detected by the magnetic sensor 14 provided in a magnetic shield 13 by a second correction unit B of the circuit unit 12.

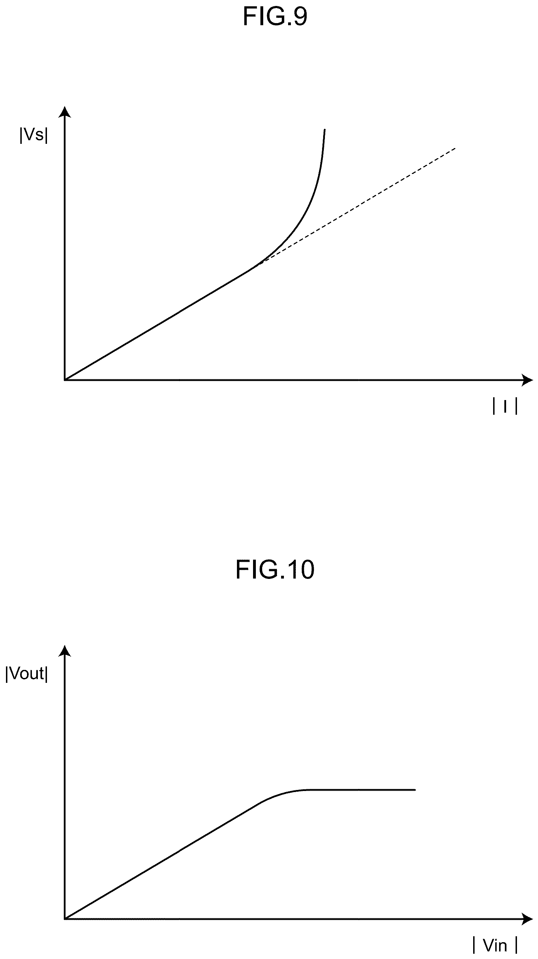

FIG. 9 is a diagram illustrating a relationship between a voltage Vs detected by the magnetic sensor 14 and a current I flowing through a conductor MC to be measured. As illustrated in FIG. 9, in a region where the current |I| flowing through the conductor MC to be measured is small, the voltage |Vs| detected by the magnetic sensor 14 increases in proportion to the current |I|. However, when the current |I| flowing through the current MC to be measured becomes a certain level or more, the influence of the magnetic saturation of the magnetic shield 13 is detected in the voltage |Vs| by the magnetic sensor 14, and the current |I| flowing through the conductor MC to be measured and the voltage |Vs| detected by the magnetic sensor 14 are not proportional to each other as illustrated in a region where the current is large in FIG. 9.

The second correction unit B according to the second embodiment includes a correction circuit B-1 that outputs a corrected voltage when the voltage from the magnetic sensor 14 is input. The correction circuit B-1 has a pass characteristic in which a gain at a high input voltage is smaller than a gain at a low input voltage. The second correction unit B desirably has a characteristic that can correct the characteristic of FIG. 9 to exhibit a linear increase.

FIG. 10 is a diagram illustrating an example of the pass characteristic of the correction circuit B-1. As illustrated in FIG. 10, in a case where the magnitude of the input voltage |Vin| is small, that is, in a case where there is no influence of the magnetic flux density saturation of the magnetic shield 13, the output voltage |Vo| has a linear characteristic with respect to the voltage |Vi|. On the other hand, as the voltage |Vin| increases, the gain of the output voltage |Vout| is reduced so that the characteristic of FIG. 9 becomes close to linearity. That is, the correction circuit B-1 of the second correction unit B according to the second embodiment performs correction of reducing the gain of the input voltage by using the pass characteristic of the circuit unit 12 on the voltage of the magnetic field in the wall of the magnetic shield 13 measured by the magnetic sensor 14. In the correction by the correction circuit B-1 of the second correction unit B, the voltage measured by the magnetic sensor 14 is corrected so as not to be affected by the magnetic flux density saturation in the magnetic shield 13. For example, the correction circuit B-1 of the second correction unit B may output a voltage corresponding to the input voltage output from the magnetic sensor 14. Furthermore, the correction circuit B-1 of second correction unit B may output a voltage obtained by multiplying the input voltage output from magnetic sensor 14 by a predetermined gain.

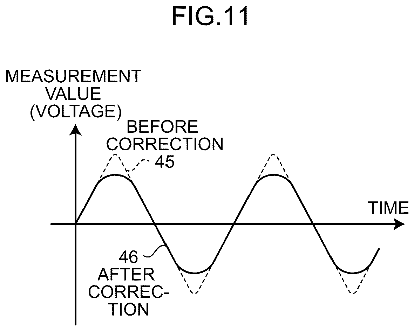

FIG. 11 is a diagram illustrating a curve 45 indicating a voltage that is a measurement value before correction and a curve 46 indicating a voltage that is a measurement value after correction in the current measurement device 1' according to the second embodiment. As illustrated in FIG. 11, the curve 46 after the correction is stable in waveform of the measurement value, and the influence of the magnetic flux density saturation of the magnetic shield 13 is reduced, as compared with the curve 45 before the correction. In other words, the curve 46 after the correction has no distortion with respect to the curve 45 before the correction.

Furthermore, the correction circuit B-1 of the second correction unit B may output a voltage corrected according to the magnitude of the input voltage output from the magnetic sensor 14. This correction is performed because the magnetic shield 13 approaches magnetic flux density saturation as the input voltage detected by the magnetic sensor 14 increases, and as a result, a difference between the voltage output from the magnetic sensor 14 and the voltage of the current flowing through the conductor MC to be measured increases, and it is necessary to perform correction of increasing the gain.

Although the case where the analog voltage measured by the magnetic sensor 14 is corrected in the current measurement device 1' of the second embodiment has been described, the second correction unit B may correct a digital voltage obtained by converting the analog voltage measured by the magnetic sensor 14.

### <3.2. Operation>

Next, operation of the current measurement device 1' according to the second embodiment will be described. In the magnetic sensor 14, a magnetic field is generated by a current flowing through the conductor MC to be measured. A part of the generated magnetic field enters the wall of the magnetic shield 13, and a magnetic field having a magnetic flux density Bs is generated in the wall of the magnetic shield 13.

The magnetic sensor 14 measures a voltage corresponding to the magnetic field generated in the magnetic shield 13, and outputs the measured voltage to the circuit unit 12.

The correction circuit B-1 of the second correction unit B of the circuit unit 12 receives the voltage output from the magnetic sensor 14 and performs correction using the pass characteristic of the circuit unit 12.

### <3.3. Effects>

Therefore, according to the current measurement device 1' of the second embodiment, the voltage corresponding to the magnetic field measured by the magnetic sensor 14 is corrected by the circuit unit 12, and thereby the influence of the magnetic flux density saturation of the magnetic shield 13 can be reduced without modifying the magnetic shield 13.

### <4. Third embodiment>

Next, a current measurement device according to the third embodiment will be described. The current measurement device according to the third embodiment corrects a digital voltage corresponding to a magnetic field measured by a magnetic sensor 14 in a circuit unit 12, as in the second embodiment. The current measurement device according to the third embodiment corrects a voltage corresponding to a magnetic field measured by the magnetic sensor 14 on the circuit unit 12 side, as with the current measurement device 1' according to the second embodiment.

### <4.1. Configuration>

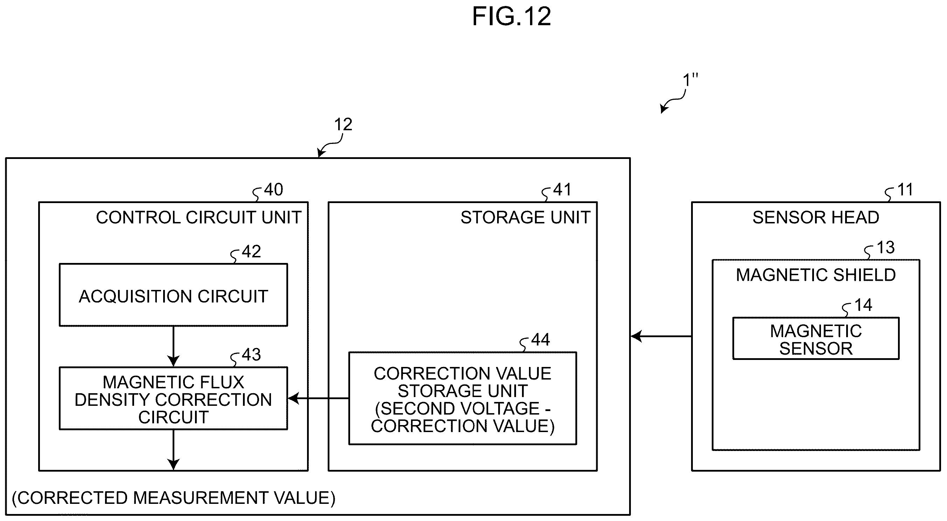

FIG. 12 is a diagram illustrating a circuit configuration of the circuit unit 12 of the current measurement device 1" according to the third embodiment. As illustrated in FIG. 12, the circuit unit 12 includes a control circuit unit 40 and a storage unit 41. The control circuit unit 40 includes an acquisition circuit 42 and a magnetic flux density correction circuit 43. The storage unit 41 includes a correction value storage unit 44.

The acquisition circuit 42 receives an analog voltage output from the magnetic sensor 14, converts the analog voltage into a digital voltage, and outputs the converted digital voltage to the magnetic flux density correction circuit 43.

In a case where the voltage acquired by the acquisition circuit 42 exceeds a sensor threshold corresponding to a magnetic flux density saturation value of the magnetic shield 13, the magnetic flux density correction circuit 43 corrects a first voltage equal to or higher than the sensor threshold among acquired voltages to reduce gain of the first voltage by using a correction value corresponding to the first voltage.

The correction value storage unit 44 stores a second voltage equal to or higher than the sensor threshold and a correction value corresponding to the second voltage. In a case where the voltage acquired by the acquisition circuit 42 is equal to or higher than the first voltage, the magnetic flux density correction circuit 43 corrects the acquired first voltage by using the correction value of the second voltage stored in the correction value storage unit 44 corresponding to the first voltage.

### <4.2. Operation>

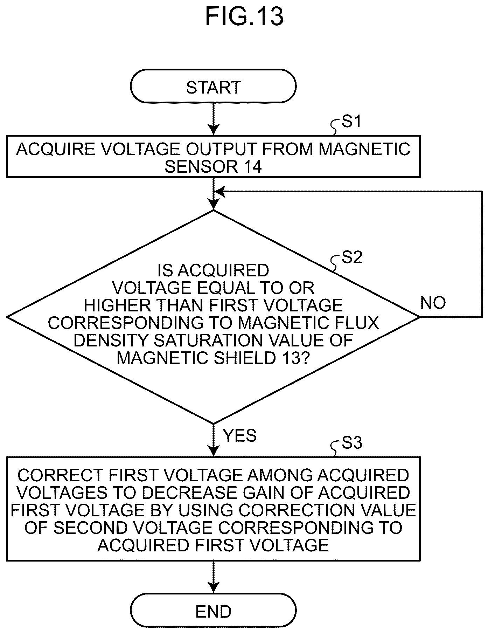

Next, operation of the current measurement device 1" according to the third embodiment will be described. FIG. 13 is a flowchart for describing operation of the current measurement device 1" according to the third embodiment.

As illustrated in FIG. 13, first, the acquisition circuit 42 acquires a voltage output from the magnetic sensor 14 (step S1).

Next, the magnetic flux density correction circuit 43 determines whether the acquired voltage is equal to or higher than the first voltage corresponding to the magnetic flux density saturation value of the magnetic shield 13 (step S2).

In a case where the voltage is not equal to or higher than the first voltage in step S2 (No in step S2), the magnetic flux density correction circuit 43 continues the determination process in step S2.

On the other hand, in a case where the sensor value is equal to or higher than the first voltage in step S2 (Yes in step S2), the magnetic flux density correction circuit 43 proceeds to the process in step S3.

In step S3, the magnetic flux density correction circuit 43 corrects the first voltage among the voltages acquired in step S1 to decrease the gain of the acquired first voltage by using the correction value of the second voltage corresponding to the acquired first voltage, and ends the process.

### <4.3. Effects>

Therefore, according to the current measurement device 1" of the third embodiment, the voltage corresponding to the magnetic field measured by the magnetic sensor 14 is corrected by the circuit unit 12, and thereby the influence of the magnetic flux density saturation of the magnetic shield 13 can be reduced without modifying the magnetic shield 13.

### <5. Fourth embodiment>

### <5.1. Configuration>

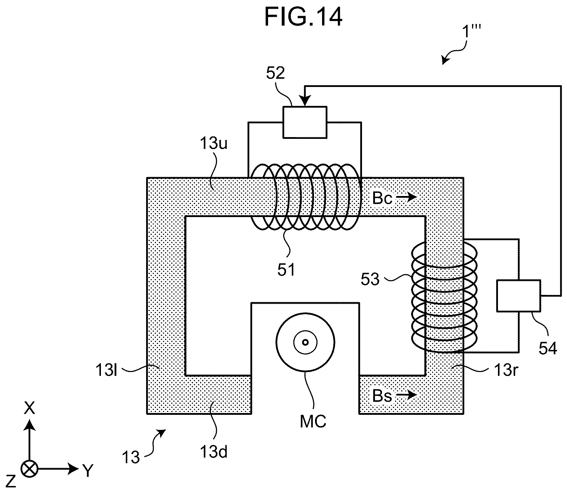

FIG. 14 is a diagram illustrating a configuration of a current measurement device 1‴ according to the fourth embodiment. As illustrated in FIG. 14, a canceling magnetic field generating coil 51 is wound around an upper portion 13u of a magnetic shield 13 while passing through an internal space of the magnetic shield 13.

A power supply circuit 52 is connected to the canceling magnetic field generating coil 51. The power supply circuit 52 supplies power to the canceling magnetic field generating coil 51. The canceling magnetic field generating coil 51 generates a magnetic field that reduces a magnetic field generated by a current flowing through a conductor MC to be measured in the magnetic shield 13. That is, the canceling magnetic field generating coil 51 generates a magnetic field having a magnetic flux density Bc in a direction of reducing a magnetic flux density Bs of the magnetic field in the magnetic shield 13.

Furthermore, a measurement coil 53 is wound around a right side portion 13r of the magnetic shield 13 while passing through the internal space of the magnetic shield 13. A detection circuit 54 is connected to the measurement coil 53.

The detection circuit 54 controls a current source of the power supply circuit 52 in a case where a voltage corresponding to a change in magnetic flux measured by the measurement coil 53 is higher than a voltage corresponding to a magnetic saturation density of the magnetic shield 13. The detection circuit 54 controls the current source of the power supply circuit 52 in a case where a change occurs in the magnetic flux measured by the measurement coil 53. In this case, the power supply circuit 52 does not always need to supply a current to the short-circuit winding 31, and therefore an energy saving effect is produced. The detection circuit 54 is connected to the measurement coil 53, and controls the current source of the power supply circuit 52 that supplies a current to the canceling magnetic field generating coil 51 based on a voltage corresponding to a change in the magnetic flux measured by the measurement coil 53.

In a case where the current source is controlled by the detection circuit 54, the power supply circuit 52 supplies a current corresponding to a voltage lower than a voltage corresponding to the magnetic saturation density of the magnetic shield 13 to the magnetic field generating coil 51. The current supplied from the power supply circuit 52 to the magnetic field generating coil 51 may be a current corresponding to a predetermined voltage or may be a current corresponding to a magnitude of a voltage corresponding to a change in the magnetic flux measured by the measurement coil 53, as long as the current is lower than the voltage corresponding to the magnetic saturation density. In a case where the current source is not controlled by the detection circuit 54, the power supply circuit 52 does not need to supply a current to the magnetic field generating coil 51.

Note that an attachment position of the canceling magnetic field generating coil 51 to the magnetic shield 13 may be the right side portion 13r, a left side portion 131, or a lower portion 13d of the magnetic shield 13 as long as the attachment position is a position where a magnetic field that reduces the influence of magnetic flux density saturation of the magnetic shield 13 is generated.

### <First modification>

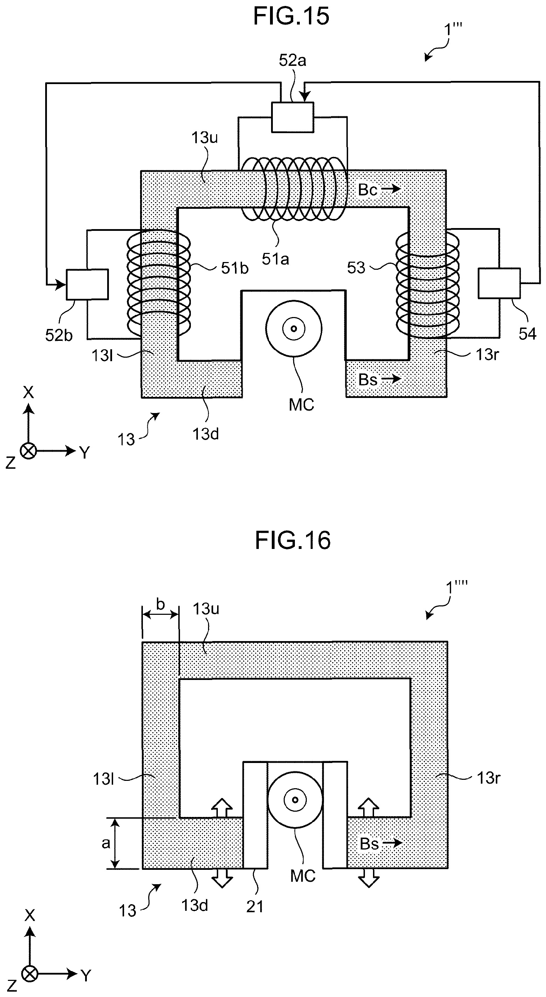

A plurality of canceling magnetic field generating coils 51 may be provided. FIG. 15 is a diagram illustrating the magnetic shield 13 according to the first modification in the current measurement device 1‴ according to the fourth embodiment. As illustrated in FIG. 15, a canceling magnetic field generating coil 51a and a canceling magnetic field generating coil 51b are wound around the magnetic shield 13 of the first modification of the current measurement device 1‴ according to the third embodiment.

Specifically, the canceling magnetic field generating coil 51a is wound around an upper portion of the magnetic shield 13, and the canceling magnetic field generating coil 51b is wound around the left side portion 131. Positions where the canceling magnetic field generating coil 51a and the canceling magnetic field generating coil 51b are wound are not limited to these positions.

A power supply circuit 52a is connected to the canceling magnetic field generating coil 51a, and a power supply circuit 52b is connected to the canceling magnetic field generating coil 51b. The power supply circuit 52a supplies power to the canceling magnetic field generating coil 51a. The power supply circuit 52b supplies power to the canceling magnetic field generating coil 51b.

### <5.2. Operation>

Next, operation of the current measurement device 1‴ according to the fourth embodiment will be described.

The detection circuit 54 controls the current source of the power supply circuit 52 to supply a current to the canceling magnetic field generating coil 51 based on a voltage corresponding to a change in the magnetic flux measured by the measurement coil 53. Specifically, the detection circuit 54 controls the current source of the power supply circuit 52 to supply a current to the canceling magnetic field generating coil 51 in a case where a voltage corresponding to a change in magnetic flux measured by the measurement coil 53 is higher than a voltage corresponding to a magnetic saturation density of the magnetic shield 13. The detection circuit 54 controls the current source of the power supply circuit 52 in a case where a change occurs in the magnetic flux measured by the measurement coil 53.

In a case where the current source is controlled by the detection circuit 54, the power supply circuit 52 supplies a current corresponding to a voltage lower than a voltage corresponding to the magnetic saturation density of the magnetic shield 13 to the magnetic field generating coil 51. Specifically, in a case where the current source is controlled by the detection circuit 54, the power supply circuit 52 supplies a current corresponding to a voltage lower than a voltage corresponding to the magnetic saturation density of the magnetic shield 13 to the magnetic field generating coil 51.

When a current flows through the conductor MC to be measured and a magnetic field is generated in the magnetic shield 13, a magnetic field having a magnetic flux density Bs is generated in the magnetic shield 13. This magnetic field is a magnetic field in a positive direction in the magnetic shield 13. In other words, the magnetic field generated by the current flowing through the conductor MC to be measured is a magnetic field in a direction from a lower portion to an upper portion of the right side portion 13r of the magnetic shield 13.

The canceling magnetic field generating coil 51 generates a magnetic field having a magnetic flux density Bc in a direction of reducing the magnetic field having the magnetic flux density Bs generated in the magnetic shield 13. That is, a current flows through the canceling magnetic field generating coil 51 in a direction such that the magnetic field having the magnetic flux density Bc is generated in a direction opposite to the magnetic field having the magnetic flux density Bs. The direction of the magnetic field generated by the canceling magnetic field generating coil 51 is opposite to the direction of the magnetic field generated by the current flowing through the conductor MC to be measured. That is, the magnetic field generated by the current flowing through the conductor MC to be measured is a magnetic field in a positive direction from the lower portion to the upper portion of the right side portion 13r of the magnetic shield 13, and the magnetic field generated by the canceling magnetic field generating coil 51 is a magnetic field in a negative direction from the upper portion to the lower portion of the right side portion 13r of the magnetic shield 13.

As illustrated in FIG. 15, even in a case where the canceling magnetic field generating coil 51a and the canceling magnetic field generating coil 51b are wound around the magnetic shield 13, the canceling magnetic field generating coil 51a and the canceling magnetic field generating coil 51b generate a magnetic field in a direction of reducing the magnetic flux density Bs of the magnetic field generated in the magnetic shield 13, similarly to the canceling magnetic field generating coil 51. That is, a current flows through the canceling magnetic field generating coil 51a and the canceling magnetic field generating coil 51b so that a magnetic field is generated in a direction opposite to the magnetic field having the magnetic flux density Bs. The direction of the magnetic fields generated by the canceling magnetic field generating coil 51a and the canceling magnetic field generating coil 51b is opposite to the direction of the magnetic field generated by the current flowing through the conductor MC to be measured. That is, the magnetic field generated by the current flowing through the conductor MC to be measured is a magnetic field in a positive direction from the lower portion to the upper portion of the right side portion 13r of the magnetic shield 13, and the magnetic field generated by the canceling magnetic field generating coil 51a and the canceling magnetic field generating coil 51b is a magnetic field in a negative direction from the upper portion to the lower portion of the right side portion 13r of the magnetic shield 13.

### <5.3. Effects>

Therefore, according to the current measurement device 1‴ of the fourth embodiment, the canceling magnetic field generating coil 51 (or the canceling magnetic field generating coil 51a and the canceling magnetic field generating coil 51b) generates a magnetic field in a direction of reducing the saturation density saturation of the magnetic shield 13, and therefore the current measurement device 1‴ is less affected by the magnetic flux density saturation of the magnetic shield 13. As a result, the current measurement device 1‴ of the fourth embodiment can accurately measure the current flowing through the conductor MC to be measured.

In addition, in a case where the plurality of canceling magnetic field generating coils 51a and 51b are used, the current measurement device 1‴ of the fourth embodiment can use coils thinner than the one magnetic field generating coil 51.

### <6. Fifth embodiment>

Next, a current measurement device according to the fifth embodiment will be described. The current measurement device according to the fifth embodiment prevents a detection value of a current flowing through a conductor MC to be measured from being disturbed due to a relationship with magnetic flux density saturation of a magnetic shield 13 by changing thickness and material of a part of the magnetic shield 13, and thus accurately measures the current flowing through the conductor to be measured.

### <6.1. Configuration>

FIG. 16 is a diagram for describing the magnetic shield 13 of the current measurement device 1ʺʺ according to the fifth embodiment. A lower portion 13d (first portion) of the magnetic shield 13 has a first cross-sectional area of a wall facing a notch portion of the magnetic shield 13. Furthermore, a right side portion 13r, a left side portion 13l, and an upper portion 13u (second portion) of the magnetic shield 13, which are portions other than the lower portion 13d, have a second cross-sectional area having a length b (a > b) smaller than the first cross-sectional area having a length a of the wall facing the notch portion of the magnetic shield 13.

Positions of the right side portion 13r, the left side portion 131, and the upper portion 13u of the magnetic shield 13 are farther from the notch portion of the magnetic shield 13 than the position of the lower portion 13d. In other words, the tip portion of the substantially U-shaped magnetic shield 13 is made thick.

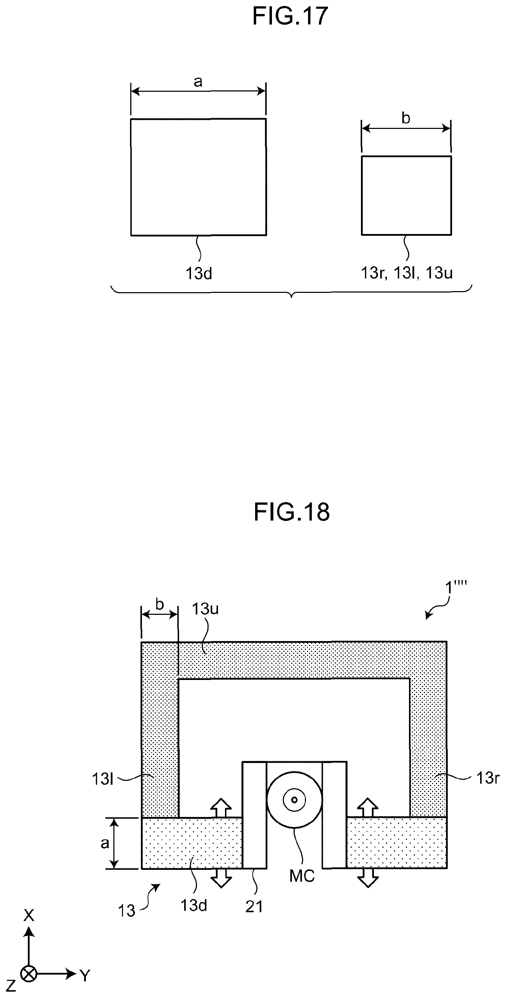

FIG. 17 is a diagram illustrating a difference between the cross-sectional area of the lower portion 13d of the magnetic shield 13 and the cross-sectional areas of the right side portion 13r, the left side portion 131, and the upper portion 13u in the current measurement device 1ʺʺ according to the fifth embodiment. As illustrated in FIG. 17, the cross-sectional area of the lower portion 13d is larger than the cross-sectional areas of the right side portion 13r, the left side portion 131, and the upper portion 13u. The shape of the cross-sectional areas is not limited to a rectangular shape, and may be another shape.

In other words, the shape of the magnetic shield 13 is changed so that magnetic flux density saturation in the tip portion of the U shape of the magnetic shield 13 which is more likely to reach saturation is increased as compared with the other portions of the magnetic shield 13.

For example, in a case where the shape is changed, the area of the portion which is more likely to reach saturation among portions of the magnetic shield 13 through which a magnetic field passes is increased. As an example, the thickness of the tip portion of the U-shaped magnetic shield 13 is increased.

### <First modification>

Next, a first modification of the current measurement device 1ʺʺ according to the fifth embodiment will be described. Although the case where the thickness of the lower portion 13d of the magnetic shield 13 is increased has been described in FIG. 16, a material of the lower portion 13d of the magnetic shield 13 is different in the first modification of the fifth embodiment.

FIG. 18 is a diagram for describing the first modification of the magnetic shield 13 in the current measurement device 1ʺʺ according to the fifth embodiment. As illustrated in FIG. 18, the magnetic shield 13 includes the lower portion 13d containing a first material and a second material different from the first material. The lower portion 13d is closer to the notch portion of the magnetic shield 13 than the right side portion 13r, the left side portion 131, and the upper portion 13u. In other words, the tip portion of the substantially U-shaped magnetic shield 13 contains the first material different from the second material.

The first material of the lower portion 13d has a higher magnetic flux density saturation value than the second material of the right side portion 13r, the left side portion 131, and the upper portion 13u.

For example, in the case where the material is changed, a material having a high saturation magnetic flux density is used in a portion which is more likely to reach saturation. As an example, the material of the tip portion of the U-shaped magnetic shield 13 is switched to a material having a high saturation magnetic flux density.

### <6.2. Operation>

Next, operation of the current measurement device 1"" according to the fifth embodiment will be described. When a current flows through the conductor MC to be measured and a magnetic field is generated in the magnetic shield 13, a magnetic field having a magnetic flux density Bs is generated in the magnetic shield 13.

Since the cross-sectional area of the lower portion 13d of the magnetic shield 13 is larger than the cross-sectional areas of the right side portion 13r, the left side portion 131, and the upper portion 13u, the lower portion 13d has a large magnetic flux density saturation value and is therefore less affected by the magnetic flux density saturation. Furthermore, since the material of the lower portion 13d of the magnetic shield 13 is a material having a larger magnetic flux density saturation value than the material of the right side portion 13r, the left side portion 131, and the upper portion 13u, the lower portion 13d has a large magnetic flux density and is therefore less affected by the magnetic flux density saturation.

### <6.3. Effects>

Therefore, the current measurement device 1ʺʺ according to the fifth embodiment can reduce the influence of magnetic flux density saturation by changing the shape and material of the magnetic shield 13. As a result, the detection value of the magnetic sensor 14 is less likely to be disturbed, and the current flowing through the conductor MC to be measured can be accurately detected.

### <Sixth embodiment>

Next, a current measurement device according to the sixth embodiment will be described. The current measurement device according to the sixth embodiment measures a current flowing through a conductor MC to be measured by adding a Rogowski sensor in addition to a magnetic sensor 14.

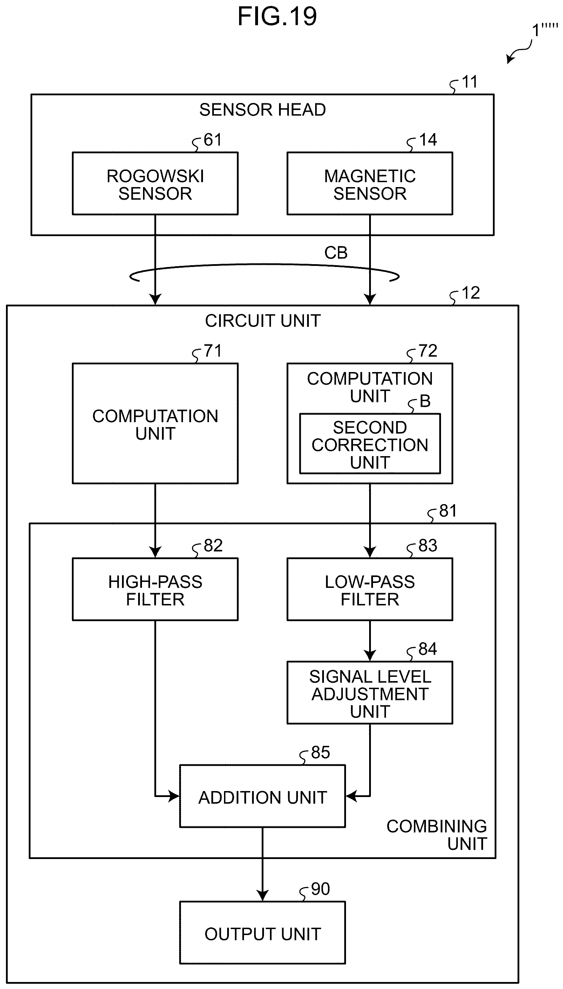

FIG. 19 is a block diagram illustrating a configuration of a main part of the current measurement device 1ʺ‴ according to the sixth embodiment. Note that, in FIG. 19, blocks corresponding to the configuration illustrated in FIG. 1 are given identical reference signs. Hereinafter, an internal configuration of a circuit unit 12 will be mainly described in detail with reference to FIG. 19. As illustrated in FIG. 19, a sensor head 11 includes a Rogonski sensor 61 in addition to the magnetic sensor 14.

The current measurement devices 1 of the first to fifth embodiments described above measure a direct-current and low-frequency component of a current I flowing through the conductor MC to be measured. On the other hand, the current measurement device 1 of the present embodiment can measure components from low to high frequencies in addition to the direct-current and low-frequency components of the current I flowing through the conductor MC to be measured.

The Rogonski sensor 61 detects an alternating-current magnetic field from a low frequency (for example, several [kHz]) to a high frequency (for example, several tens [MHz]) generated by the current I flowing through the conductor MC to be measured. The Rogowski sensor 61 is a sensor using a Rogowski coil (air core coil), and is disposed so as to surround the conductor MC to be measured. Note that one end portion of the Rogowski sensor 61 is attachable to and detachable from the sensor head 11 so that the Rogowski sensor 61 can be easily disposed around the conductor MC to be measured.

The circuit unit 12 measures the current I flowing through the conductor MC to be measured based on a detection result (detection results of the magnetic sensor 14 and the Rogowski sensor 61) output from the sensor head 11. The circuit unit 12 outputs or displays the measurement result of the current I to the outside. A cable CB is desirably flexible, is desirably easy to handle, and is desirably less likely to be disconnected, as in the first embodiment.

The circuit unit 12 includes a computation unit 71, a computation unit 72, a combining unit 81, and an output unit 90.

The computation unit 71 obtains the current I flowing through the conductor MC to be measured from the detection result of the Rogowski sensor 61. Since the Rogowski sensor 61 detects the alternating-current magnetic field from low to high frequencies as described above, the current I obtained by the computation unit 71 is a component from low to high frequencies. The detection result of the Rogowski sensor 61 indicates a voltage induced in the Rogowski coil by an alternating-current magnetic field generated around the current I (AC current) flowing through the conductor MC to be measured. The computation unit 71 performs computation to convert the detection result (voltage) of the Rogowski sensor 61 into a current value and thereby obtains the current I flowing through the conductor MC to be measured.

The computation unit 72 obtains the current I flowing through the conductor MC to be measured from the detection result of the magnetic sensor 14. Since the magnetic sensor 14 detects a direct-current magnetic field and a low-frequency alternating-current magnetic field as described above, the current I obtained by the computation unit 21 is a direct-current and a low-frequency component. Distance information indicating the reference distance r described above is stored in advance in the computation unit 72. The computation unit 71 calculates the product of the detection result (magnetic field H) of the magnetic sensor 14 and a constant uniquely determined by the reference distance r to obtain the current I flowing through the conductor MC to be measured.

Specifically, the computation unit 72 includes the second correction unit B described above. The second correction unit B performs correction for reducing influence of the magnetic flux saturation of the magnetic shield 13 on a voltage corresponding to the magnetic field detected by the magnetic field sensor 14. Then, the computation unit 72 performs computation on the voltage corrected by the second correction unit B to obtain the current I flowing through the conductor MC to be measured.

Note that the second correction unit B may be provided on the sensor head 11 side, as described above. In this case, the computation unit 72 receives the corrected voltage corresponding to the detected magnetic field from the sensor head 11, performs computation on the received voltage, and obtains the current I flowing through the conductor MC to be measured. The second correction unit B may also be provided in the computation unit 71. In this case, the computation unit 71 performs correction for reducing the influence of the magnetic flux saturation of the magnetic shield 13 on the voltage corresponding to the magnetic field detected by the Rogowski sensor 61. Then, the computation unit 71 performs computation on the voltage corrected by the second correction unit B to obtain the current I flowing through the conductor MC to be measured.

The combining unit 81 combines the computation result of the computation unit 71 and the computation result of the computation unit 72. Specifically, the combining unit 81 includes a high-pass filter 82, a low-pass filter 83, a signal level adjustment unit 84, and an addition unit 85. The low-pass filter 83 removes a high-frequency component from the computation result of the computation unit 72 and allows a low-frequency component to pass through, thereby obtaining a signal having a desired frequency characteristic suitable for combining processing, which will be described later. The high-pass filter 82 removes a low-frequency component from the computation result of the computation unit 71 and allows a high-frequency component to pass through, thereby obtaining a signal having a desired frequency characteristic suitable for combining processing, which will be described later.

The signal level adjustment unit 84 adjusts a level of a signal output from the low-pass filter 83. For example, the signal level adjustment unit 84 adjusts the signal level of the signal output from the low-pass filter 83 to match a signal level of a signal output from the high-pass filter 82 in a case where a DC current and an AC current having the same effective value flow through the conductor MC to be measured. As the signal level adjustment unit 84, for example, a variable resistor can be used.

Note that although the signal level adjustment unit 84 that adjusts only the level of the signal output from the low-pass filter 83 is provided in the present embodiment, the present embodiment is not limited to this. For example, a signal level adjustment unit that adjusts the level of the signal output from the high-pass filter 82 may be provided instead of the signal level adjustment unit 84 or may be provided in addition to the signal level adjustment unit 84. Alternatively, a signal level adjustment unit capable of adjusting a level of a first signal and a level of a second signal may be provided.

The addition unit 85 adds up the signal whose signal level has been adjusted by the signal level adjustment unit 84 and the signal output from the high-pass filter 82. The signal whose signal level has been adjusted by the signal level adjustment unit 84 is a signal indicating a direct-current and low-frequency component of the current I. The signal output from the high-pass filter 82 is a signal indicating a high-frequency component of the current I. Therefore, by adding up these signals, it is possible to obtain a signal indicating direct-current and alternating current components up to a high frequency.

The output unit 90 outputs the signal combined by the combining unit 81 (measurement result of the current I) to the outside. Note that the output unit 90 may include, for example, an output terminal that outputs a signal indicating the measurement result of the current I to the outside or may include a display device (for example, a liquid crystal display device) that displays the measurement result of the current I to the outside.

Therefore, the current measurement device 1‴ʺ according to the sixth embodiment includes the magnetic sensor 14 that is accommodated in the magnetic shield 13 and detects a direct-current magnetic field and a low-frequency alternating-current magnetic field generated by the current flowing through the conductor MC to be measured, and the Rogowski sensor 61 that detects an alternating-current magnetic field from low to high frequencies generated by the current flowing through the conductor MC to be measured. Then, the current (direct current and low-frequency alternating current) flowing through the conductor MC to be measured is obtained from the detection result of the magnetic sensor 14, the current (low to high frequencies) flowing through the conductor MC to be measured is obtained from the detection result of the Rogowski sensor 61, and the computation results are combined. Therefore, in the present embodiment, the current I (the direct-current and low-frequency component and component from low to high frequencies) flowing through the conductor MC to be measured can be measured with high accuracy in a non-contact manner while achieving a small size.

### <Seventh embodiment>

Next, a current measurement device according to the seventh embodiment will be described. The current measurement device according to the seventh embodiment measures a current flowing through a conductor MC to be measured by adding a coil 91 in addition to a magnetic sensor 14.

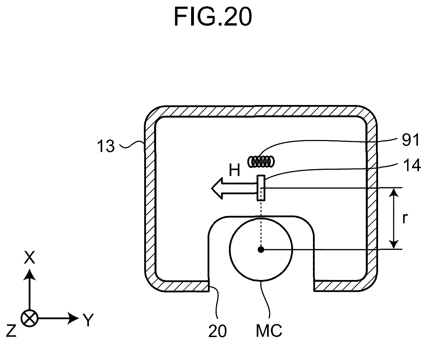

FIG. 20 is a cross-sectional view of a magnetic shield 13 of a sensor head included in the current measurement device according to the seventh embodiment. Note that FIG. 20 corresponds to FIG. 4. In the seventh embodiment, the sensor head includes the coil 91 instead of the Rogowski sensor 61 of the sensor head of the sixth embodiment.

As with the Rogowski sensor 61, the coil 91 detects an alternating-current magnetic field from a low frequency (for example, several [kHz]) to a high frequency (for example, several tens [MHz]) generated by a current I flowing through the conductor MC to be measured. The coil 91 is designed according to a maximum current (upper limit current) measurable by the current measurement device and a maximum frequency measurable by the current measurement device, and is accommodated inside the magnetic shield 12.

Specifically, the coil 91 is disposed in the magnetic shield 13 so that a detection axis (magnetic sensing direction) is in a direction of a magnetic field generated by the current I (tangential direction of the conductor MC to be measured) when the sensor head is fixed to the conductor MC to be measured by a fixing mechanism. By thus disposing the coil 91, influence of an external magnetic field flowing into the magnetic shield 12 through a notch portion 20 on the coil 91 can be reduced. In the example illustrated in FIG. 20, the coil 91 is disposed inside the magnetic shield 13 so that a distance from a center of the conductor MC to be measured is longer than a distance between the magnetic sensor 14 and the center of the conductor MC to be measured. Note that the position of the coil 91 inside the sensor head is not limited to the position illustrated in FIG. 20, and may be provided at a position different from the position illustrated in FIG. 20.

The circuit unit 12 has a configuration similar to that of the circuit unit 12 included in the current measurement device 1‴ʺ according to the sixth embodiment. The circuit configuration of the current measurement device of the present embodiment can be understood by replacing the Rogowski sensor 61 illustrated in FIG. 19 with the coil 91.

In the seventh embodiment, the magnetic sensor 14 that detects a direct-current magnetic field and a low-frequency alternating-current magnetic field generated by the current flowing through the conductor MC to be measured and the coil 91 that detects an alternating-current magnetic field from low to high frequencies generated by the current flowing through the conductor MC to be measured are accommodated in the magnetic shield 13. Then, the current (direct current and low-frequency alternating current) flowing through the conductor MC to be measured is obtained from the detection result of the magnetic sensor 14, the current (low to high frequencies) flowing through the conductor MC to be measured is obtained from the detection result of the coil 91, and the computation results are combined. Therefore, in the present embodiment, the current I (the direct-current and low-frequency component and component from low to high frequencies) flowing through the conductor MC to be measured can be measured with high accuracy in a non-contact manner while achieving a small size.

In the present embodiment, the coil 91 accommodated in the magnetic shield 13 is provided instead of the Rogowski sensor 61 provided in the current measurement device 2 of the sixth embodiment. Therefore, work of arranging the Rogowski sensor 61 (work of arranging the Rogowski sensor 61 so that the Rogowski sensor 61 surrounds the conductor MC to be measured) needed in the sixth embodiment can be omitted, and the sensor head can be further reduced in size.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

## Claims

1. A current measurement device (1) comprising:
a magnetic shield (13) having a notch portion (20) for taking a magnetic field generated by a current flowing through a conductor (MC) to be measured into an internal space;
a sensor (14) that is disposed in the internal space of the magnetic shield and outputs a voltage corresponding to a magnetic field at a position where the sensor (14) is disposed; and
a circuit unit (12) that detects the current flowing through the conductor (MC) to be measured based on the voltage output from the sensor (14), wherein
the magnetic shield (13) includes a first correction unit (A) that corrects the magnetic field measured by the sensor (14) to reduce influence of magnetic flux density saturation of the magnetic shield, and/or the magnetic shield or the circuit unit (12) includes a second correction unit (B) that corrects the voltage output from the sensor to reduce the influence of the magnetic flux density saturation of the magnetic shield (13).

2. The current measurement device (1) according to claim 1, wherein
the magnetic shield (13) has a wall defining the internal space, and
the first correction unit (A) includes a winding wound (31) around a part of the wall of the magnetic shield (13) so as to pass through the internal space.

3. The current measurement device (1) according to claim 1 or 2, wherein
the magnetic shield (13) has a hollow box shape having the internal space inside.

4. The current measurement device (1) according to any one of claims 1-3, wherein
the sensor (14) detects a direct-current magnetic field and a low-frequency alternating-current magnetic field generated by the current flowing through the conductor (MC) to be measured,
the conductor (MC) to be measured is provided in the notch portion (20),
the circuit unit (12) includes a computation unit that obtains the current flowing through the conductor (MC) to be measured based on the output voltage of the sensor (14), and
the current measurement device (1) further comprises a fixing mechanism that fixes the conductor (MC) to be measured so that a distance between a center of the conductor (MC) to be measured provided in the notch portion (20) of the magnetic shield (13) and the sensor (14) becomes a predefined reference distance.

5. The current measurement device (1) according to any one of claims 2-4, wherein
the wall of the magnetic shield (13) extends so as to have a substantially U shape when the magnetic shield (13) is viewed from a front side, and the winding is wound around the part of the wall so as to extend in a direction intersecting an extending direction of the wall of the magnetic shield (13).

6. The current measurement device (1) according to any one of claims 2-5, wherein
the winding is a winding wound (31) once around the part of the wall of the magnetic shield (13).

7. The current measurement device (1) according to any one of claims 2-5, wherein
the winding includes:
a first winding wound (31) once around a first wall of the wall of the magnetic shield (13), and
a second winding wound (31) once around a second wall of the wall of the magnetic shield (13).

8. The current measurement device (1) according to any one of claims 2-5, wherein
the winding is a winding wound (31) a plurality of times.

9. The current measurement device (1) according to any one of claims 1-8, further comprising a fixing mechanism (21) that fixes the conductor (MC) to be measured to the magnetic shield (13) so that the conductor (MC) to be measured is positioned in the notch portion (20) of the magnetic shield (13).

10. The current measurement device (1) according to any one of claims 1-9, wherein
a voltage that detects a magnetic flux overflowing from the magnetic shield (13) when the magnetic shield (13) becomes saturated is added to a voltage that detects a magnetic flux generated by the current flowing through the conductor (MC) to be measured and proportional to a magnitude of the current, so that the voltage from the sensor (14) increases, and
the second correction unit (B) corrects the voltage from the sensor (14) so as to suppress the increase in the voltage from the sensor (14).

11. The current measurement device (1) according to claim 10, wherein
the second correction unit (B) includes a correction circuit (B-1) to which the voltage from the sensor (14) is input, and
the correction circuit (B-1) has a pass characteristic in which a gain at a high input voltage is smaller than a gain at a low input voltage.

12. The current measurement device (1) according to claim 10, wherein
in a case where the voltage is higher than a sensor (14) threshold corresponding to a magnetic flux density saturation value of the magnetic shield (13), the second correction unit (B) corrects a first voltage equal to or higher than the sensor (14) threshold among the acquired voltages by using a correction value corresponding to the first voltage.

13. The current measurement device (1) according to claim 12, further comprising a correction value storage unit (44) that stores a second voltage equal to or higher than the sensor (14) threshold and a correction value corresponding to the second voltage, wherein
the second correction unit (B) corrects the first voltage by using the correction value of the second voltage corresponding to the first voltage stored in the correction value storage unit (44).

14. The current measurement device (1) according to any one of claims 2-13, wherein the first correction unit (A) includes:
a power supply circuit (52) that supplies a current for magnetic field generation to the winding,
a measurement coil (13) wound around a part of the wall of the magnetic shield (13) so as to pass through the internal space, and
a detection circuit (54) that detects a voltage generated in the measurement coil, wherein
the power supply circuit (52) supplies the current for magnetic field generation to the winding so that a magnetic field that cancels out a magnetic flux passing through the wall of the magnetic shield (13) is generated in accordance with a detection result of the detection circuit.

15. The current measurement device (1) according to claim 14, wherein
the power supply circuit (52) supplies the current for magnetic field generation to the winding in a case where the voltage detected by the detection circuit is higher than a voltage corresponding to a magnetic saturation density of the magnetic shield (13).

16. The current measurement device (1) according to any one of claims 1-15, wherein
the magnetic shield (13) has a wall defining the internal space,
the first correction unit (A) of the magnetic shield (13) includes a first wall having a cross section facing the notch portion (20) of the magnetic shield (13) and a second wall connected to the first wall on a side opposite to the notch portion (20) across the first wall, and
a cross-sectional area of the first wall is larger than a cross-sectional area of the second wall.

17. The current measurement device (1) according to any one of claims 1-15, wherein
the magnetic shield (13) has a wall defining the internal space, and
the first correction unit (A) of the magnetic shield (13) includes a first wall facing the notch portion (20) and a second wall connected to the first wall on a side opposite to the notch portion (20) across the first wall, and
a magnetic flux density saturation value of a material of the first wall is higher than a magnetic flux density saturation value of the second wall.

18. The current measurement device (1) according to any one of claims 1-17, wherein
the sensor (14) outputs a voltage corresponding to a direct-current magnetic field and a low-frequency alternating-current magnetic field generated by the current flowing through the conductor (MC) to be measured,
the current measurement device (1) further comprises a second sensor (14) that is disposed in the internal space of the magnetic shield (13) and outputs a voltage corresponding to an alternating-current magnetic field from low to high frequencies generated by the current flowing through the conductor (MC) to be measured, and
the circuit unit (12) includes:
a first computation unit (71) that corrects the voltage output from the sensor (14) to reduce the influence of the magnetic flux density saturation of the magnetic shield (13), and obtains the current flowing through the conductor (MC) to be measured from the corrected voltage,
a second computation unit (72) that obtains the current flowing through the conductor (MC) to be measured based on the voltage output from the second sensor (14), and
a combining unit (81) that combines a computation result of the first computation unit and a computation result of the second computation unit.

19. A current measurement method for a current measurement device including:
a magnetic shield having a notch portion for taking a magnetic field generated by a current flowing through a conductor to be measured into an internal space,
a sensor that is disposed in the internal space of the magnetic shield and outputs a voltage corresponding to a magnetic field at a position where the sensor is disposed, and
a circuit unit configured to detect the current flowing through the conductor to be measured based on the voltage output from the sensor, wherein
the current measurement method comprising:
correcting the magnetic field measured by the sensor to reduce influence of magnetic flux density saturation of the magnetic shield, by the magnetic shield, and/or correcting the voltage output from the sensor to reduce the influence of the magnetic flux density saturation of the magnetic shield, by the magnetic shield or the circuit unit.
